# EUROPEAN PATENT APPLICATION

(11) **EP 2 256 763 A2**
(43) Date of publication of application: **01.12.2010**
(21) Application number: 10163859.1
(22) Date of filing: 26.05.2010
(51) Int. Cl.: H01G 9/20

(54) **Metal oxide electrode for dye-sensitized solar cell, dye-sensitized solar cell, and manufacturing method of metal oxide electrode**

(30) Priority: 27.05.2009 JP 2009127545
(71) Applicant: TDK Corporation, Tokyo 103-8272 (JP)
(72) Inventor: Monden, Atsushi, Chuo-ku Tokyo 103-8272 (JP); Shinkai, Masahiro, Chuo-ku Tokyo 103-8272 (JP)
(74) Representative: Grünecker, Kinkeldey, Stockmair & Schwanhäusser Anwaltssozietät

(57) **Abstract**

Provided are a metal oxide electrode for dye-sensitized solar cell excellent in the mechanical strength of the metal oxide layer and capable of improving durability of the cell without excessively damaging the cell characteristics; a dye-sensitized solar cell excellent in cell characteristics and durability; and the like.

A metal oxide electrode for dye-sensitized solar cell has a substrate and a metal oxide layer provided on the substrate, the metal oxide layer containing a metal oxide and a phosphoric acid based surfactant. The phosphoric acid based surfactant is contained in an amount of preferably from 0.1 to 30 wt% relative to the metal oxide.

## Description

### BACKGROUND OF THE INVENTION

### Field of the Invention

The present invention relates to a metal oxide electrode for dye-sensitized solar cell, a dye-sensitized solar cell, and a manufacturing method of a metal oxide electrode.

### Description of the Related Art

There has already been reported by Gratzel et al that a dye-sensitized solar cell having a performance comparable to an amorphous silicon solar cell is available by using a porous titanium oxide electrode (refer to J. Am. Chem. Soc., 115, 6382(1993)). In recent years, application, development and research of dye-sensitized solar cells have intensively been performed in various research organizations at home and abroad. For example, it is reported that photoelectric conversion performance is exhibited also when a metal oxide such as niobium oxide, zinc oxide, tin oxide, or indium oxide, or a mixture thereof is used as well as the above-described titanium oxide.

It is the common practice to use, as a manufacturing method of the above-described metal oxide electrode, a method of applying a coating solution such as sol or slurry of metal oxide particles to the surface of a conductive substrate, thereby forming a film.

A strong bond between metal oxide particles and a strong bond between the metal oxide particles and the surface of a conductive substrate are very important for the metal oxide electrode to exhibit its performance fully. In order to form these strong bonds, conventionally known is a method of preparing a coating solution containing an adequate amount of an organic binder component such as polyethylene glycol, applying the coating solution onto a substrate, and then sintering the resulting substrate at a high temperature of 400°C or greater. In such a method requiring a high-temperature sintering treatment, a substrate containing a resin material is damaged by the treatment and therefore cannot be used virtually. As a result, the electrode thus obtained is limited in usage. Another problem that the conventional method has in addition is a large environmental burden due to a large amount of energy applied upon manufacturing.

In view of such problems, Patent Document 1 proposes (i) exposure to an ultraviolet light of 400 nm or less, (ii) heating at a temperature of 50°C or greater but less than 350°C, and (iii) exposure to microwaves as an alternative for the high-temperature sintering treatment. Patent Document 2 proposes a method of applying, onto a transparent conductive layer a dispersion containing fine particles of a metal oxide semiconductor and a binder resin, sintering at a temperature as low as about 150°C, and degreasing the binder resin to form a porous layer of the metal oxide semiconductor. These methods have however a problem that the organic binder component mixed as an essential component in the coating solution remains in the metal oxide layer and makes it difficult to realize good cell characteristics.

On the other hand, Patent Documents 3, 4 and 5 propose a manufacturing method of a metal oxide layer capable of realizing high cell characteristics even if the treatment is performed at a temperature as low as 150°C or less. More specifically, the proposed method does not incorporate an organic binder component in a sol or slurry of metal oxide fine particles. Since in the method, a bonding property between metal oxide particles and a bonding property between metal oxide fine particles and a conductive substrate surface are still insufficient, the metal oxide layer is broken or the metal oxide layer peels off from the conductive substrate surface in a durability (long-term reliability) test such as high-temperature high-humidity test or temperature cycle test.

[Patent Document 1] Japanese Patent Application Laid-Open No. 2001-357896
[Patent Document 2] Japanese Patent Application Laid-Open No. 2007-103310
[Patent Document 3] Japanese Patent Application Laid-Open No. 2004-119129
[Patent Document 4] Japanese Patent Application Laid-Open No. 2005-222838
[Patent Document 5] Japanese Patent Application Laid-Open No. 2005-251591

### SUMMARY OF THE INVENTION

The present invention has been developed in view of such a situation. An object of the invention is to provide a metal oxide electrode for dye-sensitized solar cell having a metal oxide layer excellent in mechanical strength (film strength, bond strength) and capable of improving the durability (long-term reliability) without excessively damaging cell characteristics, a dye-sensitized solar cell excellent in cell characteristics and durability (long-term reliability), and a method capable of manufacturing such a metal oxide electrode easily at a low cost and stably with good reproducibility.

The present inventors have intensively repeated researches. As a result, it has been found that the above-described problem can be overcome by using a phosphoric acid based surfactant instead of the conventional organic binder component, leading to the completion of the invention.

A metal oxide electrode for dye-sensitized solar cell according to the present invention comprises a substrate and a metal oxide layer provided on the substrate, and the metal oxide layer comprises a metal oxide and a phosphoric acid based surfactant.

The present inventors measured the characteristics of the above-described metal oxide electrode for dye-sensitized solar cell. As a result, it has been found that as compared with the conventional ones, the metal oxide layer has drastically improved mechanical strength (film strength, bond strength) and a dye-sensitized solar cell available using the metal oxide layer has greatly improved durability (long-term reliability). It has also been found that deterioration of cell characteristics which inevitably occurs when the organic binder component is incorporated is suppressed remarkably. Details of the mechanism of action for such effects have not yet been elucidated, but are presumed for example as follows.

As described above, it is desired to incorporate an organic binder component in the metal oxide layer in order to heighten the mechanical strength of the metal oxide layer. Incorporation of the organic binder component in the metal oxide layer as in the related art tends to significantly impair the cell characteristics by preventing a sensitizing dye from being supported (adsorbed) onto the surface of the metal oxide or deteriorating the wettability of the metal oxide layer, which may prevent impregnation of it in an electrolyte.
When a phosphoric acid based surfactant is incorporated in the metal oxide layer, on the other hand, such a marked deterioration in cell characteristics is suppressed. The reason is not clear, but it may be presumed that a plurality of electron attracting phosphoric acid groups preferentially interact with metal atoms on the surface of the metal oxide and as a result, the metal oxide has, on the surface thereof, a newly formed energy level and therefore has a band gap responsive to a visible light.
On the other hand, a phosphoric acid based surfactant has a low bubbling property among surfactants so that appearance of bubbles is not observed even if the phosphoric acid based surfactant is added to a slurry or sol of metal oxide particles. The bubbles mixed in the slurry or sol are also incorporated in a coated film (metal oxide layer, metal oxide film) so that such bubbles in the slurry or sol may reduce, with a high possibility, the mechanical strength of the metal oxide layer thus formed. It is therefore presumed to be advantageous to use the phosphoric acid based surfactant from the standpoint of raising the mechanical strength of a film. In addition, the phosphoric acid group can form a strong bond with a constituting element (for example, a metal element such as In or Sn) of a transparent electrode so that bond strength with the base material is heightened.
The mechanism of action is however not limited to the above-described ones.

The metal oxide layer has preferably a porous structure in which metal oxide particles have aggregated each other. Incorporation of a phosphoric acid based surfactant in the metal oxide layer strongly binds the metal oxide particles to each other and also strongly binds the metal oxide particles and the surface of the conductive substrate to markedly improve the mechanical strength of the metal oxide layer and also markedly improve the cell durability.

The phosphoric acid based surfactant is contained in an amount of preferably from 0.1 to 30 wt% relative to the metal oxide. The contents of the phosphoric acid surfactant within the above range make it possible to satisfy both cell characteristics and durability (long-term reliability), which the related art has not achieved.

The dye-sensitized solar cell according to the present invention can effectively use the above-described metal oxide electrode for dye-sensitized solar cell according to the present invention and is equipped with a metal oxide electrode having a substrate and a metal oxide layer provided thereon, a counter electrode disposed to face the metal oxide electrode, and an electrolyte provided between the metal oxide electrode and the counter electrode. The metal oxide layer comprises a metal oxide and a phosphoric acid based surfactant and at the same time has a sensitizing dye supported on the layer. Because of a reason similar to the above-described one, the metal oxide layer has preferably a porous structure in which metal oxide particles have aggregated each other. The phosphoric acid based surfactant is added in an amount of preferably from 0.1 to 30 wt% relative to the metal oxide.

A manufacturing method of a metal oxide electrode according to the present invention can effectively manufacture the above-described metal oxide electrode for dye-sensitized solar cell according to the present invention. It is a method of manufacturing a metal oxide electrode having a substrate and a metal oxide layer provided thereon. It comprises a step of preparing a mixture containing metal oxide particles and a phosphoric acid based surfactant and a step of applying the mixture to the substrate. This manufacturing method enables the manufacture of a metal oxide electrode easily at a low cost and stably with good reproducibility.

The present invention makes it possible to realize a metal oxide electrode for dye-sensitized solar cell excellent in the mechanical strength of its metal oxide layer and capable of improving durability of the cell without excessively damaging cell characteristics; and a dye-sensitized solar cell excellent in cell characteristics and durability. In addition, the manufacturing method of the present invention does not require a high-temperature sintering process employed in the related art and can manufacture a metal oxide electrode easily at a low cost and stably with good reproducibility so that the present invention is advantageous from the viewpoint of productivity and economy.

### BRIEF DESCRIPTION OF THE DRAWINGS

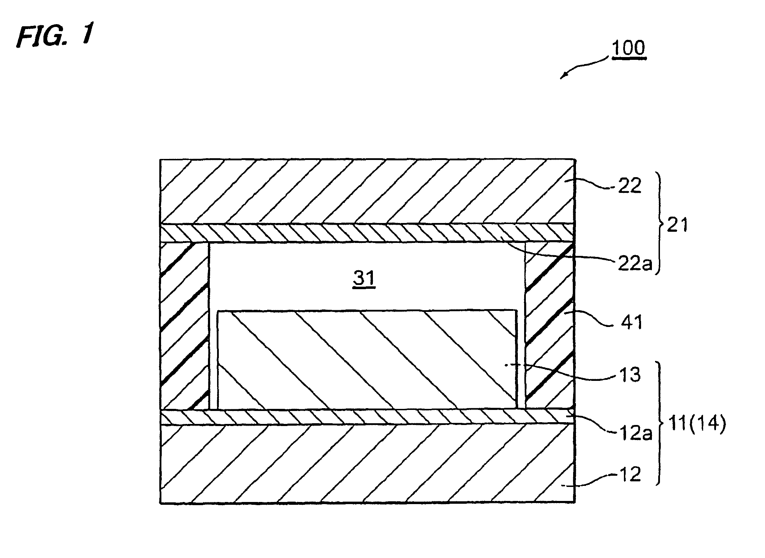

FIG. 1 is a cross-sectional view illustrating the schematic constitution of a dye-sensitized solar cell 100 and a metal oxide electrode 14.

### DESCRIPTION OF THE PREFERRED EMBODIMENTS

Embodiments of the present invention will hereinafter be described. It is to be noted that the same element is denoted with the same reference numeral, and overlapping description is omitted. Moreover, positional relations of top, bottom, left, right and the like are based on a positional relation shown in the drawing unless otherwise mentioned particularly. Furthermore, a dimensional ratio of the drawing is not limited to a shown ratio. The following embodiments merely illustrate the present invention, and the present invention is not limited only to the embodiments.

FIG. 1 is a cross-sectional view illustrating the schematic constitution of the dye-sensitized solar cell according to the present embodiment.
The dye-sensitized solar cell 100 is equipped with a dye-supported electrode 11 functioning as a working electrode, a counter electrode 21, and an electrolyte 31 provided between the dye supporting electrode 11 and the counter electrode 21. The dye-supported electrode 11 and the counter electrode 21 are disposed so as to face each other via a spacer 41. An electrolyte 31 is sealed in a sealing space defined by the dye-supported electrode 11, the counter electrode 21, the spacer 41, and a sealing member not illustrated in the drawing.

The dye-supported electrode 11 is equipped with a metal oxide electrode 14 having, on a conductive surface 12a of a substrate 12, a porous metal oxide layer 13 containing a metal oxide and a phosphoric acid based surfactant and the metal oxide layer 13 has a sensitizing dye supported (adsorbed) thereon. In other words, in the dye-supported electrode 11 according to the present embodiment, the metal oxide layer 13 having a sensitizing dye supported (adsorbed) thereon, that is, a complex structure having a sensitizing dye supported (adsorbed) on the surface of a metal oxide is stacked over the conductive surface 12a of the substrate 12.

No particular limitation is imposed on the kind, size, or shape of the substrate 12 insofar as it can support at least the metal oxide layer 13. For example, a plate-like or sheet-like substrate is preferably used. Specific examples of it include glass substrates, substrates made of plastics such as polyethylene terephthalate, polyethylene, polypropylene or polystyrene, metal substrates, alloy substrates, and ceramic substrates, and stacks thereof The substrate 12 is preferably light permeable and that having excellent light permeability in a visible light region is more preferred. Further, the substrate 12 has preferably flexibility. A substrate having flexibility can have structures in various forms making use of its flexibility.

The conductive surface 12a can be provided on the substrate 12 by forming on the substrate 12 a transparent conductive film such as a conductive PET film. Alternatively, the substrate 12 having conductivity may be used, which enables omission of the treatment for providing the conductive surface 12a on the substrate 12. Specific examples of the transparent conductive film include, but not particularly limited to, indium-tin oxide (ITO), indium-zinc oxide (IZO), SnO_{2,} InO₃ and, in addition, FTO obtained by doping SnO₂ with fluorine. These conductive films may be used either singly or in combination. No particular limitation is imposed on the formation method of the transparent conductive film and publicly known methods such as deposition, CVD, spraying, spin coating and immersion can be used. The thickness of the transparent conductive film can be determined as needed. The conductive surface 12a of the substrate 12 may be subjected to an appropriate surface modification treatment, if necessary. Specific examples of the treatment include, but not particularly limited to, publicly known surface treatments such as degreasing treatment with a surfactant, an organic solvent, or an alkaline aqueous solution, mechanical polishing treatment, immersion treatment in an aqueous solution, preliminary electrolysis treatment with an electrolyte, washing treatment with water, and drying treatment.

The metal oxide layer 13 is a porous semiconductor layer having, as a main component thereof, a metal oxide such as TiO₂, ZnO, SnO₂ WO₃, or Nb₂O₅. The metal oxide layer 13 may contain a metal such as titanium, tin, zinc, iron, tungsten, zirconium, strontium, indium, cerium, vanadium, niobium, tantalum, cadmium, lead, antimony, or bismuth, or a metal oxide or metal chalcogenide thereof The thickness of the metal oxide layer 13 is not particularly limited, but it is preferably from 0.05 to 50 µm.

The phosphoric acid based surfactant contained in the metal oxide layer 13 is a surfactant having a phosphoric acid group. By adding the phosphoric acid based surfactant, the resulting metal oxide layer 13 has drastically improved mechanical strength (film strength, bond strength) and durability (long-term reliability) and in addition, deterioration in initial characteristics of it can be suppressed as compared with the conventional method of adding an organic binder. It is therefore important, from such a viewpoint, that the phosphoric acid based surfactant is contained in the metal oxide layer 13. The phosphoric acid based surfactant is preferably an anionic surfactant containing a phosphoric acid group, of which the surfactant having, as a side chain thereof, alkyl groups having phosphoric acid as a polymer main chain is more preferred. Specific examples include polyoxyethylene alkyl ether phosphoric acid and polyoxyethylene alkyl phenyl ether phosphoric acid. The alkyl groups have preferably from about 12 to 20 carbon atoms and the alkyl groups contained in the molecule may have either the same or different length. Typical examples of it include, but not particularly limited to, polyoxyethylene lauryl ether phosphoric acid, polyoxyethylene lauryl phenyl ether phosphoric acid, polyoxyethylene stearyl ether phosphoric acid, and polyoxyethylene stearyl phenyl ether phosphoric acid.

Although the content of the phosphoric acid based surfactant contained in the metal oxide layer 13 is not particularly limited, it is preferably from 0.1 to 30 wt%, more preferably from 0.3 to 20 wt%, still more preferably from 0.5 to 15 wt%. The greater the content of the phosphoric acid based surfactant, the mechanical strength and durability are likely to be excellent. On the other hand, as the content of the phosphoric acid based surfactant is smaller, the metal oxide layer is likely to be excellent in initial characteristics. The content of the phosphoric acid based surfactant may be determined as needed in consideration of these balance.

The formation method of the metal oxide layer 13 is not particularly limited and a publicly known method can be used. Examples include a method of providing a mixture containing metal oxide particles and a phosphoric acid based surfactant on the conductive surface 12a of the substrate 12 and then firing the resulting substrate and a method of providing such a mixture on the conductive surface 12a of the substrate 12 and then subjecting the resulting substrate to a low temperature treatment at from about 50 to 150°C, preferably at from about 70 to 150°C. Using such a method facilitates preparation of the metal oxide layer 13 having a porous structure in which the metal oxide particles have aggregated each other. Of these methods, the latter method of carrying out a low temperature treatment at from about 50 to 150°C is preferred from the standpoints that a resin-containing substrate is usable and an environmental burden can be reduced due to a decrease in the amount of an applied energy. The method of providing the mixture to the surface of the substrate is not particularly limited and a conventionally known process of application or the like can be used.

The mixture containing the metal oxide particles and the phosphoric acid based surfactant is preferably a mixture liquid (for example, dispersion, sol, or slurry) containing a dispersion medium. Specific examples of the dispersion medium include water, and various organic solvents such as methanol, isopropyl alcohol, butanol, dichloromethane, acetone, acetonitrile, ethyl acetate, toluene, dimethylformamide, ethoxyethanol, and cyclohexanone. They may be used either singly or in combination. Further, the mixture may contain another surfactant, an acid, or an auxiliary agent such as chelating agent if necessary.

There is no particular limitation imposed on the sensitizing dye to be supported on the metal oxide layer 13 and the dye may be any of a water-soluble dye, a water-insoluble dye or an oil-soluble dye. The sensitizing dye having a desired optical absorption band/absorption spectrum may be selected as needed depending on the performance which a photoelectric conversion element is required to have. Specific examples of the sensitizing dye include xanthene dyes such as eosin-Y, coumarin dyes, triphenylmethane dyes, cyanine dyes, merocyanine dyes, phthalocyanine dyes, naphthalocyanine dyes, porphyrin dyes, and polypyridine metal complex dyes. Additional examples include ruthenium bipyridium dyes, azo dyes, quinone dyes, quinonimine dyes, quinacridone dyes, squarium dyes, perylene dyes, indigo dyes, oxonol dyes, polymethine dyes, and riboflavin dyes. Examples of the sensitizing dye are not particularly limited to those described above. They may be used either singly or in combination. From the viewpoint of increasing an amount of the dye to be supported, the sensitizing dye has preferably an adsorptive group which interacts with the metal oxide. Specific examples of the adsorptive group include, but not limited to, carboxyl group, sulfonic acid group, and phosphoric acid group.

Examples of the method of supporting the sensitizing dye on the metal oxide layer 13 include a method of immersing the metal oxide layer 13 in a solution containing a sensitizing dye and a method of applying a solution containing a sensitizing dye to the metal oxide layer 13. The solvent of the sensitizing-dye-containing solution can be selected as needed from publicly known solvents such as water, ethanol solvent, nitrile solvent, and ketone solvent, depending on the solubility or compatibility of the sensitizing dye selected for use.

The dye-supported electrode 11 (metal oxide electrode 14) may have an intermediate layer between the conductive surface 12a of the substrate 12 and the metal oxide layer 13. The material of the intermediate layer is not particularly limited and, for example, the above-described metal oxides for use in the transparent conductive film 12a are preferred. The intermediate layer can be formed by precipitating or depositing the metal oxide on the conductive surface 12a of the substrate 12 by a publicly known technique such as deposition, CVD, spraying, spin coating, immersion, or an electrolysis. The intermediate layer has preferably light permeability, more preferably light permeability and conductivity. Although the thickness of the intermediate layer is not particularly limited, it is preferably from about 0.1 to 5 µm.

The counter electrode 21 is comprised of a substrate 22 having thereon a conductive surface 22a and is disposed so that the conductive surface 22a faces the metal oxide layer 13 of the dye-supported electrode 11. As the substrate 22 and the conductive surface 22a, publicly known ones similar to those employed as the substrate 12 and the conductive surface 12a may be employed as needed. Usable are, for example, as well as the substrate 12 having conductivity, the substrate 12 having thereon the transparent conductive film 12a, and the substrate 12 having, on the transparent conductive film 12a thereof, a film made of a metal such as platinum, gold, silver, copper, aluminum, indium, molybdenum, or titanium, carbon, or a conductive polymer.

As the electrolyte 31, there may be used electrolytes ordinarily used in a cell or a solar cell such as a redox electrolyte solution, a semi-solid electrolyte obtained by gelling the redox electrolyte solution, and a film formed of a solid-state hole transport material of a p-type semiconductor. Examples of a typical electrolyte solution for dye-sensitized solar cells include acetonitrile solutions, ethylene carbonate solutions, and propylene carbonate solutions, each containing iodine and an iodide and/or bromine and a bromide, and mixtures of these solutions. The concentration of the electrolyte and additives to the electrolyte may be determined or selected as needed, depending on the required performance. Specific examples of the additive include, but not particularly limited to, p-type conductive polymers such as polyaniline, polyacetylene, polypyrrole, polythiophene, polyphenylene, and poly(phenylene vinylene), and derivatives thereof, molten salts having an imidazolium ion, pyridinium ion, or triazolium ion, or a derivative thereof and a halogen ion in combination, gelling agents, oil gelling agents, dispersing agents, surfactants, and stabilizers.

The present invention will hereinafter be described in detail by Examples and Comparative Examples. It should however be borne in mind that the present invention is not limited to or by them.

### (Example 1)

First, a titanium oxide sol was prepared in the following procedure.
Titanium isopropoxide (125 ml) was added to 750 ml of a 0.1M aqueous nitric acid solution while stirring. Further, the resulting mixture was stirred vigorously at 80°C for 8 hours. The reaction mixture thus obtained was subjected to an autoclave treatment at 230°C for 16 hours in a pressure vessel made of Teflon (trade mark). The sol thus obtained was stirred to re-suspend the precipitate. The precipitate which had remained without being re-suspended was removed by suction filtration and the sol was concentrated by using an evaporator until the concentration of titanium oxide reached 11 wt%. To the resulting sol was added 5 wt% of polyoxyethylene lauryl ether phosphoric acid ("Phosphanol ML-220", trade name, product of Toho Chemical Industry) based on the weight of titanium oxide. The resulting mixture was then stirred for one hour.
The sol thus obtained was diluted with methanol to give its titanium oxide concentration of 2 wt% to obtain the titanium oxide sol of Example 1.

A metal oxide electrode (titanium oxide electrode) was manufactured in the following procedure by using the titanium oxide sol of Example 1.
First, a conductive polycarbonate film resin substrate (size: 2.0 cm long, 1.5 cm wide, and 0.1 mm thick, sheet resistance: 30 Ω/)□ was prepared by forming as a conductive film an ITO film with a thickness of about 600 nm on the surface of a polycarbonate film base material by sputtering. Then, a masking tape with a thickness of 70 µm having a 0.5-cm long and 0.5-cm wide square hole made therein was adhered onto the conductive film of the resulting conductive polycarbonate film resin substrate. The titanium oxide sol was sprayed toward the square hole to provide the titanium oxide sol onto the conductive film exposed inside of the square hole. Then, the masking tape was peeled off, followed by heating in an electric oven at 100°C for 30 minutes to form a metal oxide layer (titanium oxide film) containing the metal oxide and the phosphoric acid based surfactant. The heating was performed at a temperature increasing rate of 2°C/min.
The metal oxide layer was then treated with an alkali solution in order to remove the nitric acid component contained in the resulting metal oxide layer. Described specifically, in a 2 wt% aqueous ammonia/methanol dilute solution used as the alkali solution, the metal oxide layer was immersed for 30 minutes. Then, the metal oxide layer was taken out from the solution, washed with methanol, and dried at 80°C for 10 minutes.
The above-described procedure yielded the metal oxide electrode (titanium oxide electrode) of Example 1 having, on the conductive surface of the substrate, the metal oxide layer (titanium oxide film) containing the metal oxide and the phosphoric acid based surfactant. The film thickness of the metal oxide layer was measured to be about 6 µm.

A metal oxide electrode (titanium oxide electrode) similar to the above-described one was manufactured and thermogravimetric analysis (TGA) of the metal oxide layer (titanium oxide film) was performed. As a result, it was confirmed that the metal oxide layer contained polyoxyethylene lauryl ether phosphoric acid in an amount of 4.1 wt% relative to titanium oxide. The thermogravimetric analysis was performed under the following conditions. By using a TG/DTA 22 apparatus manufactured by Seiko Instruments, 2 mg of a sample was collected and set on a sample holder. At the same time, a reference sample was also set on a reference holder. After circulation of an He gas as an atmospheric gas around the sample was started at a flow rate of 300 mL/min in the apparatus, temperature increase was started from room temperature under a temperature increase program at a rate of 10°C/min and a mass change of the sample at the time was measured (room temperature to 500°C).

A metal oxide electrode (titanium oxide electrode) similar to the above-described one was manufactured and a bond strength of its metal oxide layer (titanium oxide film) to the conductive polycarbonate film resin substrate was evaluated. Evaluation of the bond strength was performed in accordance with the cross-cut cellophane tape peel test in JIS K5400. Described specifically, the metal oxide layer (titanium oxide film) was cross-cut in a grid form at intervals of 1 mm and a cellophane tape ("CT24", trade name; product ofNichiban) was adhered firmly to the metal oxide layer with the ball of a finger. Then, the tape was peeled off. After the tape peel test, the proportion (%) of the grids of the metal oxide layer (titanium oxide film) which had remained on the substrate was calculated. As a result, the proportion of the grids of the titanium oxide film which had remained after the peel test was 96%, revealing that the mechanical strength was sufficient.

A dye-supported electrode was then manufactured using the metal oxide electrode of Example 1.
The metal oxide electrode was immersed in 20 ml of an anhydrous ethanol solution to which (4,4'-dicarboxylic acid-2,2'-bipyridine)ruthenium (II) diisocyanate had been added as a sensitizing dye at a concentration of 3×10⁻⁴ M and it was left to stand for 12 hours. Then, the electrode was taken out from the solution, washed with anhydrous acetonitrile, and then dried naturally. It was confirmed that the metal oxide layer of the electrode thus obtained became deep red due to the ruthenium dye supported (adsorbed) thereon.
In the above-described procedure, the dye-supported electrode of Example 1 having, on the conductive surface of the substrate, the metal oxide layer having a sensitizing dye supported on the surface of the metal oxide was obtained.

A dye-sensitized solar cell was manufactured in the following procedure by using the dye-supported electrode of Example 1.
First, a spacer 1.5 cm long, 1.5 cm wide, and 70 µm thick having therein a 0.5-cm long and 0.5-cm wide square hole was placed on the metal oxide electrode (titanium oxide electrode) so that the position of the square hole coincides with the position of the metal oxide layer (titanium oxide film) having thereon the sensitizing dye. An electrolyte was then filled in the square hole. A counter electrode 30 was then placed on the spacer, followed by sealing the periphery with an epoxy resin to obtain the dye sensitized solar cell of Example 1. As the electrolyte, a methoxypropionitrile solution containing tetrapropyl ammonium iodide (0.4M) and iodine (0.04M) was used. As the counter electrode, a conductive glass having 100-nm thick platinum deposited thereon was used.

The cell characteristics of the dye-sensitized solar cell obtained in Example 1 were measured using an AM-1.5 solar simulator (1000 W/m²). The cell characteristics were measured using the following four items, that is, open-circuit voltage (Voc), light current density (Jsc), fill factor (FF), and conversion efficiency (η). The open-circuit voltage (Voc) means a voltage between two output terminals of a solar cell module when they are opened. The light current density (Jsc) means an electric current (per cm²) that flows between two output terminals of the solar cell module when they are short-circuited. The fill factor (FF) means a value (FF=Pmax/(VocxJsc)) obtained by dividing the maximum output Pmax by the product of the open-circuit voltage (Voc) and the light current density (Jsc) and it is a parameter indicating the characteristic of the current-voltage characteristic curve as a solar cell. The photoelectric conversion energy (η) can be obtained by sweeping the voltage of a photoelectric conversion element with a source meter and measuring a response current. A quotient obtained by dividing the maximum output, that is, a product of voltage and current, by light intensity per cm² is multiplied by 100 and given in percentage. It is represented by (maximum output/light intensity per cm²) × 100. These results are shown in Table 1.

In addition, in order to evaluate durability (long-term reliability), a photoelectric conversion efficiency was measured after the cell was left to stand for 100 hours at 60°C and 95%RH and after a temperature cycle test (6 hours × 10 times per cycle) at from 60°C to -20°C, respectively, and variations (%) from the previously measured (initial) photoelectric conversion efficiency were calculated. These results are also shown in Table 1.

### (Example 2)

In a manner similar to that of Example 1 except that polyoxyethylene lauryl ether phosphoric acid was added in an amount of 30 wt% based on the weight of titanium oxide, a titanium oxide sol of Example 2 was prepared. In a manner similar to that of Example 1 except for the use of the titanium oxide sol of Example 2, a metal oxide electrode, a dye-supported electrode, and a dye-sensitized solar cell of Example 2 were manufactured and the above-described various measurements were made on them. The results are shown in Table 1.

### (Example 3)

First a zinc oxide slurry was prepared in the following procedure.
Commercially available zinc oxide particles ("nano ZINC100", trade name; product of Honjo Chemical) were added to toluene in an amount of 30 wt% based on the weight of toluene, followed by the addition of polyoxyethylene stearyl ether phosphoric acid ("Phosphanol RL-310", trade name; product ofToho Chemical) in an amount of 4 wt% based on the weight of zinc oxide. The resulting mixture was dispersed for 30 minutes in a paint shaker to obtain a zinc oxide slurry of Example 3.

A metal oxide electrode (zinc oxide electrode) was manufactured in the following procedure by using the zinc oxide slurry of Example 3.
First, a conductive polycarbonate film resin substrate (size: 2.0 cm long, 1.5 cm wide, and 0.1 mm thick, sheet resistance: 30 Ω/□) having flexibility was prepared by forming an ITO film with a thickness of about 600 nm as a conductive film on the surface of a polycarbonate film base material by sputtering. Then, a 70-µm thick masking tape having therein a 0.5-cm long and 0.5-cm wide square hole was adhered onto the conductive film of the resulting conductive polycarbonate film resin substrate. The zinc oxide slurry was spin coated at 500 rpm onto the conductive film exposed inside of the square hole. Then, the masking tape was peeled off and the resulting substrate was heated in an electric oven at 100°C for 30 minutes. The heating was performed at a temperature increasing rate of 2°C/min. The spin coating and heat treatment were repeated five times to form a metal oxide layer (zinc oxide film) containing the metal oxide and the phosphoric acid based surfactant.
The above-described procedure yielded the metal oxide electrode (zinc oxide electrode) of Example 3 having, on the conductive surface of the substrate, the metal oxide layer (zinc oxide film) containing the metal oxide and the phosphoric acid based surfactant. The film thickness of the metal oxide layer was measured to be about 5 µm.

A metal oxide electrode (zinc oxide electrode) similar to the above-described one was manufactured and thermogravimetric analysis (TG) of it was performed. As a result, it was confirmed that the metal oxide layer (zinc oxide film) contained polyoxyethylene stearyl ether phosphoric acid in an amount of 3.5 wt% relative to zinc oxide.

A metal oxide electrode (zinc oxide electrode) similar to the above-described one was manufactured and a bond strength of the metal oxide layer (zinc oxide film) to a conductive polycarbonate film resin substrate was evaluated. Evaluation of the bond strength was performed by a cross-cut test in which the surface of the metal oxide layer (zinc oxide film) was cross-cut in a grid form and the proportion (%) of the grids of the metal oxide layer (zinc oxide film) which had remained on the substrate after the tape peel test was counted. As a result, the proportion of the grids of the zinc oxide film which had remained after the peel test was 95%, revealing that the mechanical strength was sufficient.

A dye-supported electrode was then manufactured in the following procedure by using the metal oxide electrode of Example 3.
D149 (product of Mitsubishi Paper Mills) was used as a sensitizing dye and the metal oxide electrode was immersed in a 0.5M D149 solution (t-butanol/acetonitrile = 1/1 mixed solvent). After it was left to stand for 1 hour, the electrode was taken out from the solution, washed with acetonitrile, and then dried naturally. It was confirmed that the metal oxide layer of the electrode thus obtained became deep red due to D149 supported (adsorbed) on the metal oxide layer.
The above-described procedure yielded the dye-supported electrode of Example 3 having, on the conductive surface of the substrate, the metal oxide layer having the sensitizing dye supported on the surface of the metal oxide.

In a manner similar to that of Example 1 except for the use of the dye-supported electrode of Example 3, a dye-sensitized solar cell of Example 3 was manufactured and the above-described various measurements were made on them. The results are shown in Table 1.

### (Example 4)

In a manner similar to that of Example 3 except that polyoxyethylene stearyl ether phosphoric acid was added in an amount of 1 wt% based on the weight of zinc oxide, a zinc oxide slurry of Example 4 was prepared. In a manner similar to that of Example 3 except for the use of the zinc oxide slurry of Example 4, a metal oxide electrode, a dye-supported electrode, and a dye-sensitized solar cell of Example 4 were manufactured and the above-described various measurements were made on them. The results are shown in Table 1.

### (Example 5)

In a manner similar to that of Example 3 except that polyoxyethylene stearyl ether phosphoric acid was added in an amount of 10 wt% based on the weight of zinc oxide, a zinc oxide slurry of Example 5 was prepared. In a manner similar to that of Example 3 except for the use of the zinc oxide slurry of Example 5, a metal oxide electrode, a dye-supported electrode, and a dye-sensitized solar cell of Example 5 were manufactured and the above-described various measurements were made on them. The results are shown in Table 1.

### (Example 6)

In a manner similar to that of Example 3 except that polyoxyethylene stearyl ether phosphoric acid was added in an amount of 20 wt% based on the weight of zinc oxide, a zinc oxide slurry of Example 6 was prepared. In a manner similar to that of Example 3 except for the use of the zinc oxide slurry of Example 6, a metal oxide electrode, a dye-supported electrode, and a dye-sensitized solar cell of Example 6 were manufactured and the above-described various measurements were made on them. The results are shown in Table 1.

### (Example 7)

In a manner similar to that of Example 3 except that polyoxyethylene stearyl ether phosphoric acid was added in an amount of 30 wt% based on the weight of zinc oxide, a zinc oxide slurry of Example 7 was prepared. In a manner similar to that of Example 3 except for the use of the zinc oxide slurry of Example 7, a metal oxide electrode, a dye-supported electrode, and a dye-sensitized solar cell of Example 7 were manufactured and the above-described various measurements were made on them. The results are shown in Table 1.

### (Example 8)

In a manner similar to that of Example 1 except that polyoxyethylene lauryl ether phosphoric acid was replaced with polyoxyethylene lauryl phenyl ether phosphoric acid, a titanium oxide sol of Example 8 was prepared. In a manner similar to that of Example 1 except for the use of the titanium oxide sol of Example 8, a metal oxide electrode, a dye-supported electrode, and a dye-sensitized solar cell of Example 8 were manufactured and the above-described various measurements were made on them. The results are shown in Table 1.

### (Example 9)

In a manner similar to that of Example 3 except that polyoxyethylene stearyl ether phosphoric acid was replaced with polyoxyethylene stearyl phenyl ether phosphoric acid, a zinc oxide slurry of Example 9 was prepared. In a manner similar to that of Example 3 except for the use of the zinc oxide slurry of Example 9, a metal oxide electrode, a dye-supported electrode, and a dye-sensitized solar cell of Example 9 were manufactured and the above-described various measurements were made on them. The results are shown in Table 1.

### (Comparative Example 1)

In a manner similar to that of Example 1 except that polyoxyethylene lauryl ether phosphoric acid was not added, a titanium oxide sol of Comparative Example 1 was prepared. In a manner similar to that of Example 1 except for the use of the titanium oxide sol of Comparative Example 1, a metal oxide electrode, a dye-supported electrode, and a dye-sensitized solar cell of Comparative Example 1 were manufactured and the above-described various measurements were made on them. The results are shown in Table 1.

### (Comparative Example 2)

In a manner similar to that of Example 3 except that polyoxyethylene stearyl ether phosphoric acid was not added, a zinc oxide slurry of Comparative Example 2 was prepared. In a manner similar to that of Example 3 except for the use of the zinc oxide slurry of Comparative Example 2, a metal oxide electrode, a dye-supported electrode, and a dye-sensitized solar cell of Comparative Example 2 were manufactured and the above-described various measurements were made on them. The results are shown in Table 1.

### (Comparative Example 3)

In a manner similar to that of Example 1 except that polyoxyethylene lauryl ether phosphoric acid was replaced with polyethylene glycol (having a molecular weight of 4000, product of Wako Pure Chemicals), a titanium oxide sol of Comparative Example 3 was prepared. In a manner similar to Example 1 except for the use of the titanium oxide sol of Comparative Example 3, a metal oxide electrode, a dye-supported electrode, and a dye-sensitized solar cell of Comparative Example 3 were manufactured and the above-described various measurements were made on them. The results are shown in Table 1.

### (Comparative Example 4)

In a manner similar to that of Example 1 except that polyoxyethylene lauryl ether phosphoric acid was replaced with sodium polyoxyethylene lauryl ether sulfate ("Emal 20C", trade name; product of Kao), a titanium oxide sol of Comparative Example 4 was prepared. In a manner similar to Example 1 except for the use of the titanium oxide sol of Comparative Example 4, a metal oxide electrode, a dye-supported electrode, and a dye-sensitized solar cell of Comparative Example 4 were manufactured and the above-described various measurements were made on them. The results are shown in Table 1.

| | Metal oxide electrode | | | | Dye-sensitized solar cell | | | | | |
|---|---|---|---|---|---|---|---|---|---|---|
| | Components of metal oxide layer | | | Tape peel test | (Initial) cell characteristics | | | | Variation in conversion efficiency | |
| | Metal oxide | Additive | Content of additive (measured value) (wt%) | Remaining ratio of grids in crosscut test (%) | Jsc (mA/cm²) | Voc (V) | FF | Conversion efficiency (%) | After left to stand at 60°C and 95%RH for 100 hr (%) | After temperature cycle test (6 hr × 10 times per cycle) (%) |
| Ex. 1 | Titanium oxide | Polyoxyethylene lauryl ether phosphoric acid | 4.1 | 96 | 11 | 0.74 | 0.58 | 4.72 | -7 | -11 |
| Ex. 2 | Titanium oxide | Polyoxethylene lauryl ether phosphoric acid | 29.0 | 100 | 4.4 | 0.69 | 0.47 | 1.43 | 0 | -4 |
| Ex. 3 | Zinc oxide | Polyoxyethylene stearyl ether phosphoric acid | 3.5 | 95 | 11.3 | 0.65 | 0.6 | 4.41 | -7 | -10 |
| Ex. 4 | Zinc oxide | Polyoxyethylene stearyl ether phosphoric acid | 0.8 | 91 | 12.1 | 0.66 | 0.6 | 4.79 | -10 | -15 |
| Ex. 5 | Zinc oxide | Polyoxyethylene stearyl ether phosphoric acid | 9.4 | 98 | 11 | 0.64 | 0.6 | 4.22 | -5 | -7 |
| Ex. 6 | Zinc oxide | Polyoxyethylene stearyl ether phosphoric acid | 19.2 | 98 | 9.7 | 0.65 | 0.56 | 3.53 | -3 | -7 |
| Ex. 7 | Zinc oxide | Polyoxyethylene stearyl ether phosphoric acid | 28.3 | 100 | 3.9 | 0.67 | 0.45 | 1.18 | -2 | -5 |
| Ex. 8 | Titanium oxide | Polyoxyethylene lauryl phenyl ether phosphoric acid | 4.6 | 95 | 11.5 | 0.73 | 0.6 | 5.04 | -6 | -10 |
| Ex. 9 | Zinc oxide | Polyoxyethylene stearyl phenyl ether phosphoric acid | 3.7 | 95 | 11.6 | 0.66 | 0.63 | 4.82 | -8 | -12 |
| Comp Ex. 1 | Titanium oxide | - | 0 | 15 | 11.9 | 0.72 | 0.56 | 4.80 | -81 | -100 |
| Comp Ex. 2 | Zinc oxide | - | 0 | 10 | 12.8 | 0.62 | 0.61 | 4.84 | -85 | -100 |
| Comp Ex. 3 | Titanium oxide | Polyethylene glycol | 5.0 | 72 | 0.8 | 0.31 | 0.55 | 0.14 | -22 | -36 |
| Comp Ex. 4 | Titanium oxide | Sodium polyoxyethylene lauryl ether sulfate | 4.9 | 55 | 1.2 | 0.44 | 0.58 | 0.31 | -38 | -45 |

It has been confirmed from Examples 1 to 9 and Comparative Examples 1 and 2 that by incorporating the phosphoric acid based surfactant in the metal oxide layer, the resulting metal oxide layer has dramatically improved mechanical strength and the dye-sensitized solar cell available using the metal oxide layer has greatly improved durability (long-term reliability). It has also been confirmed that both excellent cell characteristics and excellent durability (long-term reliability), which have not been achieved conventionally, can be achieved by adjusting the content of the phosphoric acid based surfactant.

It has been confirmed from the comparison with Comparative Examples 3 and 4 that the conventional organic binder component or another surfactant, on the other hand, does not have a sufficient effect for improving the mechanical strength of the metal oxide layer and durability (long-term reliability) of the dye-sensitized solar cell. Furthermore, the solar cell does not exhibit good cell characteristics.

These findings have revealed that the phosphoric acid based surfactant is, different from another polymer compound or another surfactant, a unique additive capable of enhancing mechanical strength (film strength, bond strength) of the metal oxide layer and durability (long-term reliability) of the dye-sensitized solar cell without excessively impairing the cell performance.

As described above, the present invention is not limited to or by the above embodiments and examples, but can be modified as needed without departing from the scope of the invention.

As described above, the present invention can realize an electrode excellent in the mechanical strength of its metal oxide layer and capable of improving the durability of a cell without excessively impairing the cell characteristics. In addition, the electrode is excellent from the viewpoints of productivity, economy, and versatility. The invention can therefore be used widely and effectively in electronic/electrical materials, electronic/electrical devices, and various apparatuses, equipment, and systems equipped therewith. In particular, the present invention can be used effectively in the fields of photoelectric conversion elements and dye-sensitized solar cells.

### [Description of Numerical Reference]

11... dye-supported electrode; 12... substrate; 12a... conductive surface; 13... metal oxide layer; 14... metal oxide electrode; 21... counter electrode; 22a... conductive surface; 22... substrate; 31... electrolyte; 41... spacer; 100... photoelectric conversion element.
The present application is based on Japanese priority applications No. 2009-127545 filed on May 27, 2009, the entire contents of which are hereby incorporated by reference.

## Claims

1. A metal oxide electrode for dye-sensitized solar cell, which comprising:
a substrate, and
a metal oxide layer provided on the substrate;
wherein the metal oxide layer comprises a metal oxide and a phosphoric acid based surfactant.

2. The metal oxide electrode for dye-sensitized solar cell according to Claim 1,
wherein the metal oxide layer has a porous structure in which metal oxide particles have aggregated.

3. The metal oxide electrode for dye-sensitized solar cell according to Claim 1 or 2,
wherein the phosphoric acid based surfactant is contained in an amount of from 0.1 to 30 wt% relative to the metal oxide.

4. A dye-sensitized solar cell, which comprising:
a metal oxide electrode having a substrate and a metal oxide layer provided on the substrate,
a counter electrode disposed to face the metal oxide electrode, and
an electrolyte provided between the metal oxide electrode and the counter electrode;
wherein the metal oxide layer comprises a metal oxide and a phosphoric acid based surfactant and at the same time, has a sensitizing dye supported on the metal oxide layer.

5. The dye-sensitized solar cell according to Claim 4,
wherein the metal oxide layer has a porous structure in which metal oxide particles have aggregated.

6. The dye-sensitized solar cell according to Claim 4 or 5,
wherein the phosphoric acid based surfactant is contained in an amount of from 0.1 to 30 wt% relative to the metal oxide.

7. A manufacturing method of a metal oxide electrode having a substrate and a metal oxide layer provided on the substrate, which comprising:
a step of preparing a mixture containing metal oxide particles and a phosphoric acid based surfactant, and
a step of applying the mixture to the substrate.
